# EUROPEAN PATENT APPLICATION

(11) **EP 4 340 020 A1**
(43) Date of publication of application: **20.03.2024**
(21) Application number: 22196166.7
(22) Date of filing: 16.09.2022
(51) Int. Cl.: H01L 23/495

(54) **A METHOD FOR MANUFACTURING A SEMICONDUCTOR PACKAGE ASSEMBLY AS WELL AS A SEMICONDUCTOR PACKAGE ASSEMBLY OBTAINED WITH THIS METHOD**

(71) Applicant: Nexperia B.V., 6534 AB Nijmegen (NL)
(72) Inventor: Fan, Haibo, Kwaichung (HK); Zhou, Zhou, Kwaichung (HK); Leung, Chi Ho, Hong Kong (HK)
(74) Representative: Pjanovic, Ilija

(57) **Abstract**

According to a first example of the disclosure, a method for manufacturing a semiconductor package assembly is proposed, which results in a semiconductor package assembly with a more even distributed stress concentrations, reduced solder crack occurrences and limited solder filler joint connections. The method comprises the steps of forming at least one semiconductor package by means of the sub-steps: providing a lead frame made from a metal material having a first frame side and a second frame side opposite to the first frame side as well as having at least two terminals; providing at least one silicon die structure having a first die side and a second die side opposite to the first side with its second die side on the first frame side of the lead frame; electrically and mechanically attaching the at least one silicon die structure to the terminals of the lead frame; and encapsulating the at least one silicon die structure and the plurality of terminals with a molding resin leaving at least a portion of at least two terminals exposed, thereby forming at least one encapsulated semiconductor package assembly; wherein the method further comprises the step of plating the exposed portions of the at least two terminals with a metal plating material, with the metal plating material being the same as the metal material of the lead frame.

## Description

### TECHNICAL FIELD

The present disclosure relates to techniques for manufacturing a semiconductor package assembly, wherein a silicon die structure is mounted to a lead frame having terminals and encapsulated with a molding resin, as well as a semiconductor package assembly obtained with these techniques.

### BACKGROUND OF THE DISCLOSURE

Solderability issues for both Quad Flat Pack No-lead (QFN) products and flat lead products have been mentioned due to termination of lead material underside of the packages for solder joints. Solder fillets cannot easily be formed due to copper oxidation without applying a tin plating technique after the sawing process step. This phenomenon can easily trigger solder cracks during thermal cycling tests (TCT) or power cycling tests (IOL) caused by a thermal expansion mismatch between the solder material, the lead frame material and the PCB.

Therefore, wettable flank features by step cut or dimple is recommended to be adopted at the terminals side wall for tin plating and to allow a good solder fillet joint to be created at those locations. However, in this way a solder fillet joint is only formed at the terminals side walls, which are exterior of the package, and no solder fillets are formed at the terminals side walls interior of the package. In particular at those locations at the interior of the package, where higher stress concentrations trigger solder crack initiation and propagation towards the outer direction.

Accordingly, an object of the present disclosure is to provide a manufacturing technique obviating the above identified problems of higher stress concentrations, increased solder crack occurrences and limited solder filler joint connections.

### SUMMARY OF THE DISCLOSURE

According to a first example of the disclosure, a method for manufacturing a semiconductor package assembly is proposed, which results in a semiconductor package assembly with a more even distributed stress concentrations, reduced solder crack occurrences and limited solder filler joint connections.

The method comprises the steps of
i) forming at least one semiconductor package by means of the sub-steps:
   i1) providing a lead frame made from a metal material having a first frame side and a second frame side opposite to the first frame side as well as having at least two terminals;
   i2) providing at least one silicon die structure having a first die side and a second die side opposite to the first side with its second die side on the first frame side of the lead frame;
   i3) electrically and mechanically attaching the at least one silicon die structure to at least two terminals of the lead frame;
      and
ii) encapsulating the at least one silicon die structure and the at least two terminals with a molding resin leaving at least a portion of the at least two terminals exposed, thereby forming at least one encapsulated semiconductor package assembly;
   wherein the method further comprises the step of:
   iii) plating the exposed portion of the at least two terminals with a metal plating material, with the metal plating material being the same as the metal material of the lead frame.

By forming a layer of additional plating material on the exposed portions of the terminals, , with the metal plating material being the same as the metal material of the lead frame, the solder covering area and solder fillet formation is purposely promoted to enhance the solder joint reliability in the semiconductor package assembly (semiconductor device). Accordingly, this new terminal configuration resists or limits solder cracking from occurring during thermal cycling tests.

In an additional example of the method according to the disclosure, step iii) comprises plating the exposed portions of the at least two terminals with a layer of 30-50 µm of metal plating material.

As the metal plating material is the same as the metal material of the lead frame, an optimal promotion of the solder fillet formation and enhancing the solder joint reliability is ensured. Preferably, the metal plating material is Copper and likewise the lead frame material is also Copper.

In a further example, step iv) is applied after step ii) but before step iii), wherein step iv) concerns subjecting the exposed portions of the at least two terminals with to a surface roughening treatment, for example using a chemical agent. Herewith the plating of the exposed portion of the terminal is significantly improved, further enhancing the solder joint reliability.

Additionally, the method for manufacturing a semiconductor package assembly according to the disclosure comprises the step v), being performed after step iii) or step iv), of plating the exposed plated portions of the at least two terminals with a further metal plating material different from the metal plating material used in the plating step iii). Preferably, said further metal plating material is Tin.

Finally, the method according to the disclosure comprises the step vi), performed after step v), of singulating the encapsulated semiconductor package from the lead frame, thereby forming a single semiconductor package assembly.

Likewise the disclosure pertains to a semiconductor package assembly composed of a silicon die structure electrically and mechanically attached to at least two terminals and encapsulated by a molding resin such that a portion of the at least two terminals is exposed, wherein the exposed portions of the at least two terminals are plated with a metal plating material according to the method steps of the present disclosure.

In particular examples, the semiconductor package assembly is a leadless semiconductor package assembly or a leaded semiconductor package assembly.

### BRIEF DESCRIPTION OF THE DRAWINGS

The disclosure will now be discussed with reference to the drawings, which show in:
Figures 1a-1c several process steps for manufacturing a semiconductor package assembly according to a prior art example;
Figures 2a-2d several process steps for manufacturing a leadless semiconductor package assembly according to an example of the disclosure;
Figures 3a-3c spatial views of several process steps for manufacturing a flat-leaded semiconductor package assembly according to another example of the disclosure;
Figures 4a-4b comparative charts of solder strain cycle tests using prior art semiconductor package assemblies and a semiconductor package assembly according to the disclosure.

### DETAILED DESCRIPTION OF THE DISCLOSURE

For a proper understanding of the disclosure, in the detailed description below corresponding elements or parts of the disclosure will be denoted with identical reference numerals in the drawings.

As outlined in the introductionary part of this patent application, solderability issues for both Quad Flat Pack No-lead (QFN) (leadless) products and flat lead (leaded) products have been mentioned due to termination of lead material underside of the packages for solder joints. Solder fillets cannot easily be formed due to copper oxidation without applying a tin plating technique after the sawing process step. This phenomenon can easily trigger solder cracks during thermal cycling tests (TCT) or power cycling tests (IOL) caused by a thermal expansion mismatch between the solder material, the lead frame material and the PCB. In particular at those locations at the interior of the package, where higher stress concentrations trigger solder crack initiation and propagation towards the outer direction.

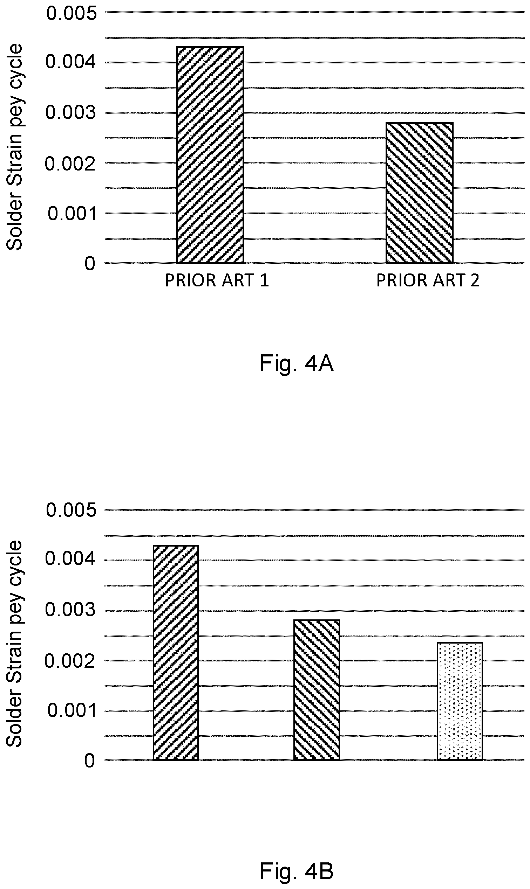

Especially for large QFN products, there is much higher strain on the PCB solder connection near inner side of the terminal. In Figure 4a, a chart is shown depicting the results of solder strain cycle tests using two prior art semiconductor package assemblies. The solder strain cycle tests conducted on the two prior art semiconductor package assemblies indicated a much higher risk on PCB solder cracking during reliability testing.

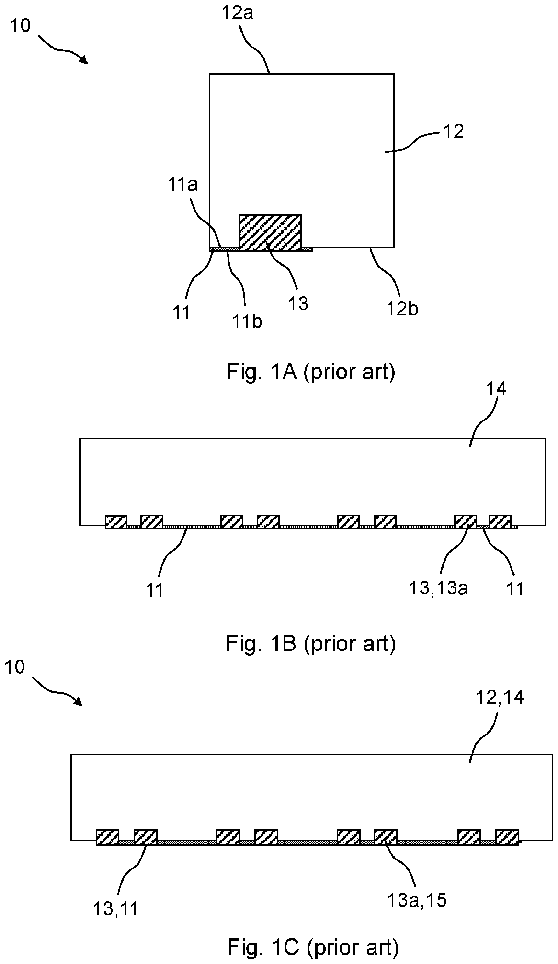

In the prior art, and for an explanation reference is made to Figures 1a-1c, for manufacturing a known semiconductor package assembly 10, the process steps implemented concern in general a first step of providing a lead frame 11 made from a metal material, with the lead frame 11 having a first frame side 11a and a second frame side 11b opposite to the first frame side 11. Such known lead frame 11 also has a plurality of terminals 13. The subsequent step in the prior art is providing at least one silicon die structure 12 having a first die side 12a and a second die side 12b opposite to the first side 12a with its second die side 12b on the first frame side 11a of the lead frame 11. Herewith the at least one silicon die structure 12 is electrically and mechanically attached to the terminals 13 of the lead frame 11. See Figure 1a.

In a subsequent step, shown in Figure 1b, the at least one silicon die structure 12 and the plurality of terminals 13 are encapsulated with a molding resin 14 leaving at least a portion 13a of the terminals 13 exposed, thereby forming at least one encapsulated semiconductor package assembly 10.

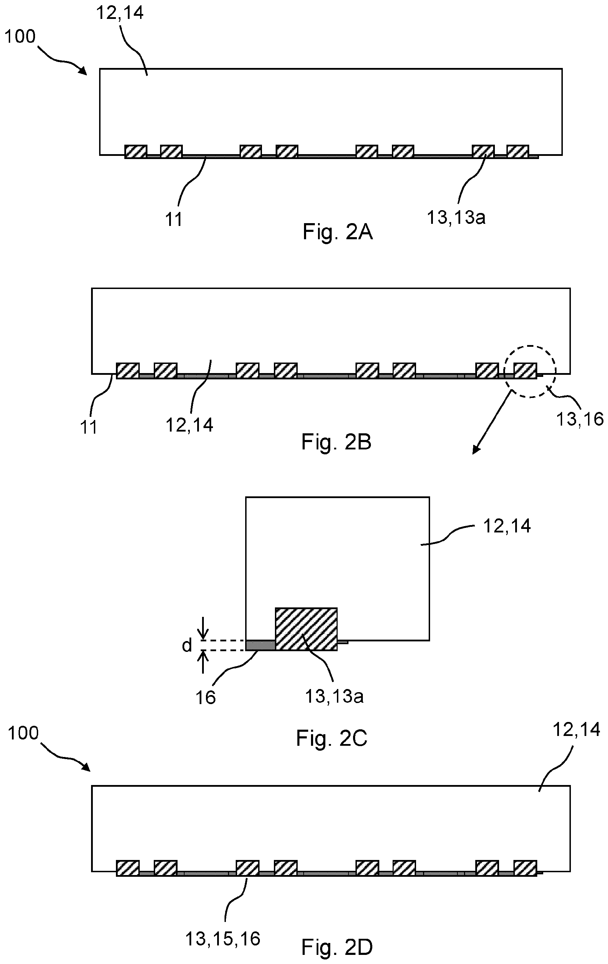

The disclosure proposes in an improved method for manufacturing a semiconductor package assembly, which results in a semiconductor package assembly with a more even distributed stress concentrations, reduced solder crack occurrences and limited solder filler joint connections. For clarification of an example of the method according to the disclosure, reference is made to Figures 2a-2d, 3a-3c and Figure 4b.

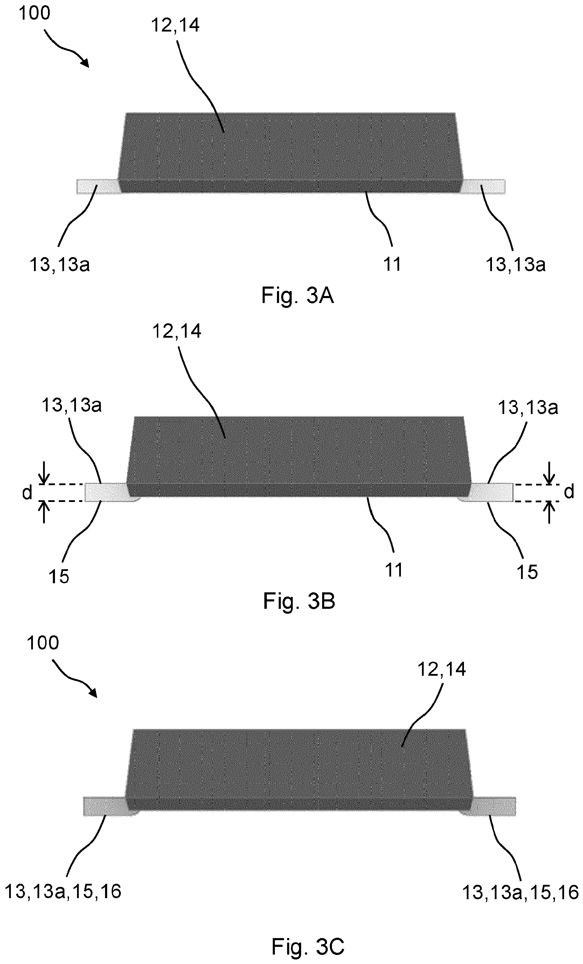

Note that Figures 2a-2d pertain to an example of the method according to the disclosure, wherein a leadless semiconductor package assembly is manufactured, whereas Figures 3a-3c pertain to an example of the method according the disclosure manufacturing a flat-leaded semiconductor package assembly.

In a similar fashion as outlined in Figures 1a and 1b, the process steps according to the disclosure are in general the same. In Figure 2a/3a, the first step pertains to providing a lead frame 11 made from a metal material, with the lead frame 11 having a first frame side 11a and a second frame side 11b opposite to the first frame side 11. Such known lead frame 11 also has at least two terminals 13, wherein the terminals 13 in Figure 2a are considered leadless terminals, and in Figure 3a flat-leaded terminals. Subsequently, at least one silicon die structure 12 having a first die side 12a and a second die side 12b opposite to the first side 12a is provided with its second die side 12b on the first frame side 11a of the lead frame 11. Herewith the at least one silicon die structure 12 is electrically and mechanically attached to the at least two terminals 13 of the lead frame 11. See Figure 2a.

In a subsequent step, also shown in Figure 2a/3a, the at least one silicon die structure 12 and the at least two terminals 13 are encapsulated with a molding resin 14 leaving at least a portion 13a of the terminals 13 exposed, thereby forming at least one encapsulated semiconductor package assembly.

In an additional step iii) of the method according to the disclosure, the exposed portions 13a of the at least two terminals 13 are plated with a metal plating material 16. It is preferred that in the method according to the disclosure, during the plating step iii), the exposed portions 13a of the at least two terminals 13 are plated with a layer of metal plating material 16 with a thickness d of 30-50 µm. See Figure 2c/3b.

Also the metal plating material 16 is the same as the metal material of the lead frame 11 and the terminals 13, thus ensuring an optimal promotion of the solder fillet formation and enhancing the solder joint reliability. Preferably, the metal plating material 16 is Copper and likewise the lead frame material 11, 13 is also Copper.

This configuration provides a manufacturing technique obviating the known identified problems in the prior art of higher stress concentrations, increased solder crack occurrences and limited solder filler joint connections.

By forming a layer of additional plating material 16 on the exposed portions 13a of the at least two terminals 13, it is achieved that the solder covering area and solder fillet formation is purposely promoted to enhance the solder joint reliability in the semiconductor package assembly (semiconductor device) 100. Accordingly, this new terminal configuration resists or limits solder cracking from occurring during thermal cycling tests.

To further enhance the solder joint reliability and improving the plating of the exposed portions 13a of the terminals 13, after step ii) but before step iii), the exposed portions 13a of the at least two terminals 13 is subjected to a surface roughening treatment step iv), for example using a chemical agent.

Next, as shown in Figure 2d/3c, a step v) is being performed after step iii) or step iv), and pertains to plating the exposed plated portions 13a/16 of the at least two terminals 13 with a further metal plating material 15 different from the metal plating material 16 used in the first plating step iii). Preferably, said further metal plating material 15 is Tin.

Finally, similarly as in the prior a step vi) is performed after step iii) or v) of singulating the encapsulated semiconductor package from the lead frame, thereby forming a single semiconductor package assembly 100.

The result is a semiconductor package assembly according to the disclosure, being composed of a silicon die structure 12 electrically and mechanically attached to at least two terminals 13 and encapsulated by a molding resin 14 such that a portion 13a of the at least two terminals 13 is exposed, wherein the exposed portions 13a of the at least two terminals 13 is plated with a metal plating material 16, with the metal plating material 16 being the same as the metal material of the lead frame 11, according to the method steps of the present disclosure.

In particular examples, the semiconductor package assembly 100 is a leadless semiconductor package assembly as depicted in Figures 2a-2d or a (flat-)leaded semiconductor package assembly 100 as depicted in Figures 3a-3c.

The resulting semiconductor package assembly 100 according to the disclosure exhibits more evenly distributed stress concentrations, with reduced solder crack occurrences and limited solder filler joint connections. This is shown in Figure 4b, which depicts a chart showing the results of solder strain cycle tests of the two prior art semiconductor package assemblies of Figure 4a but now also compared with similar test data obtained with an example of a semiconductor package assembly 100 according to the disclosure. Figure 4b shows that the semiconductor package assembly 100 according to the disclosure exhibits less solder strain in its terminals 13 being provided with the additional plated layer 16 of the same material as the material of the terminal 13. Accordingly, the chart of Figure 4b shows that semiconductor package assembly 100 according to the disclosure has a much less risk on PCB solder cracking during reliability testing that the two prior art semiconductor package assemblies indicated as PRIOR ART 1 and PRIOR ART 2.

### LIST OF REFERENCE NUMERALS USED

- 10: semiconductor package assembly (according to the prior art)
- 100: semiconductor package assembly (according to the disclosure)
- 11: lead frame
- 11a: first frame side
- 11b: second frame side
- 12: silicon die structure
- 12a: first die side
- 12b: second die side
- 13: terminals
- 13a: exposed portion of terminal
- 14: molding resin
- 16: first metal plating material
- 15: further metal plating material different from
- d: thickness of first metal plating material layer

## Claims

1. A method for manufacturing a semiconductor package assembly, the method comprising the steps of
i) forming at least one semiconductor package by means of the sub-steps:
i1) providing a lead frame made from a metal material having a first frame side and a second frame side opposite to the first frame side as well as having at least two terminals;
i2) providing at least one silicon die structure having a first die side and a second die side opposite to the first side with its second die side on the first frame side of the lead frame;
i3) electrically and mechanically attaching the at least one silicon die structure to the terminals of the lead frame;
and
ii) encapsulating the at least one silicon die structure and the plurality of terminals with a molding resin leaving at least a portion of at least two terminals exposed, thereby forming at least one encapsulated semiconductor package assembly;
wherein the method further comprises the step of:
iii) plating the exposed portion of the at least two terminals with a metal plating material, with the metal plating material being the same as the metal material of the lead frame.

2. The method for manufacturing a semiconductor package assembly according to claim 1, wherein step iii) comprises plating the exposed portion of the at least two terminals with a layer of 30-50 µm of metal plating material.

3. The method for manufacturing a semiconductor package assembly according to claim 1 or 2, further comprising the step of
iv) after step ii) but before step iii), subjecting the exposed portion of the at least two terminals with to a surface roughening treatment, for example using a chemical agent.

4. The method for manufacturing a semiconductor package assembly according to any one or more of the claims 1-3, further comprising the step of
v) after step iii) or step iv), plating the exposed plated portion of the at least two terminals with a further metal plating material different from the metal plating material used in the plating step iii).

5. The method for manufacturing a semiconductor package assembly according to any one or more of the claims 1-4, further comprising the step
vi) after step v), singulating the encapsulated semiconductor package from the lead frame, thereby forming a single semiconductor package assembly.

6. A semiconductor package assembly composed of a silicon die structure electrically and mechanically attached to at least two terminals and encapsulated by a molding resin such that a portion of the at least tw terminals are exposed, wherein the exposed portions of the at least two terminals are plated with a metal plating material according to the method steps of one or more of the method claims 1-5.

7. The semiconductor package assembly according to claim 6, wherein the semiconductor package assembly is a leadless semiconductor package assembly.

8. The semiconductor package assembly according to claim 6, wherein the semiconductor package assembly is a leaded semiconductor package assembly.
